(19) Europäisches Patentamt / European Patent Office / Office européen des brevets

(11) **EP 4 213 974 B1**

(12) **EUROPÄISCHE PATENTSCHRIFT**

(45) Veröffentlichungstag und Bekanntmachung des Hinweises auf die Patenterteilung:
**31.12.2025 Patentblatt 2026/01**

(21) Anmeldenummer: **21778484.2**

(22) Anmeldetag: **21.09.2021**

(51) Internationale Patentklassifikation (IPC):
**B01D 67/00** (2006.01)  **B01D 71/02** (2006.01)
**B81C 1/00** (2006.01)  **C23C 18/16** (2006.01)
**C23C 18/31** (2006.01)  **H01M 4/38** (2006.01)

(52) Gemeinsame Patentklassifikation (CPC):
**B01D 67/0039; B01D 67/0062; B01D 67/0093; B01D 71/0213; B81C 1/00087; C23C 18/08; H01M 4/366; H01M 4/38; H01M 4/386; H01M 4/62;** B01D 2325/02; Y02E 60/10

(86) Internationale Anmeldenummer:
**PCT/EP2021/075912**

(87) Internationale Veröffentlichungsnummer:
**WO 2022/058610 (24.03.2022 Gazette 2022/12)**

(54) **HIERARCHISCH PORÖSE STRUKTUR UND PROZESS ZUR HERSTELLUNG DERSELBIGEN**

HIERARCHICALLY POROUS STRUCTURE AND PROCESS FOR PRODUCING SAME

STRUCTURE POREUSE HIÉRARCHIQUE ET SON PROCÉDÉ DE PRODUCTION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.09.2020 DE 102020124532**

(43) Veröffentlichungstag der Anmeldung:
**26.07.2023 Patentblatt 2023/30**

(73) Patentinhaber: **Technische Universität Hamburg**
**21073 Hamburg (DE)**

(72) Erfinder:
• **GRIES, Stella Inge Martha**
**22769 Hamburg (DE)**
• **BRINKER, Manuel**
**22765 Hamburg (DE)**
• **HUBER, Patrick**
**22305 Hamburg (DE)**

(74) Vertreter: **Koplin, Moritz**
**Anne-Conway-Straße 1**
**28359 Bremen (DE)**

(56) Entgegenhaltungen:
**US-A1- 2014 335 411**

• **BAHADORI SHAHAB RANJBAR ET AL:** "New Insight into Single-Crystal Silver Dendrite Formation and Growth Mechanisms", CRYSTAL GROWTH & DESIGN, vol. 20, no. 11, 24 September 2020 (2020-09-24), US, pages 7291 - 7299, XP055867018, ISSN: 1528-7483, DOI: 10.1021/acs.cgd.0c00953
• **SILAKOV G O ET AL:** "Influence of the Formation Temperature of the Morphology of-Si Formed by Pd-Assisted Chemical Etching", SEMICONDUCTORS, AMERICAN INSTITUTE OF PHYSICS. NEW YORK, US, vol. 54, no. 8, 1 August 2020 (2020-08-01), pages 890 - 894, XP037211481, ISSN: 1063-7826, [retrieved on 20200805], DOI: 10.1134/S1063782620080229
• **"SPRINGER SERIES IN MATERIALS SCIENCE",** vol. 220, 1 January 2015, SPRINGER, BERLIN, DE, ISSN: 0933-033X, article ABEL SANTOS ET AL: "Electrochemical Etching Methods for Producing Porous Silicon", pages: 1 - 36, XP055344340, DOI: 10.1007/978-3-319-20346-1_1

EP 4 213 974 B1

• **EDUARD MONAICO ET AL: "Porous semiconductor compounds", SEMICONDUCTOR SCIENCE TECHNOLOGY, IOP PUBLISHING LTD, GB, vol. 35, no. 10, 31 August 2020 (2020-08-31), pages 103001, XP020357149, ISSN: 0268-1242, [retrieved on 20200831], DOI: 10.1088/1361-6641/ AB9477**

**Beschreibung**

GEBIET

Die vorliegende Erfindung bezieht sich auf hierarchisch poröse Strukturen und einen Prozess zur Herstellung derselbigen. Insbesondere bezieht sich die vorliegende Erfindung auf hierarchisch poröse Siliziumstrukturen, hierarchisch poröse Quarzglasstrukturen und einen Prozess zur Herstellung derselbigen.

HINTERGRUND

Aus der DE 10348541 A1 ist bekannt, dass es möglich ist, durch die anodische Auflösung von Silizium in einem flusssäurehaltigen Elektrolyt Mesoporen in einer makroporösen Siliziumstruktur zu erzeugen. Eine Erzeugung von Durchgangsporen in den Porenwänden der Makroporen ist auf diese Weise jedoch nicht möglich, da die Porenspitzen eine Verarmung an Ladungsträgern erfahren, welche die Auflösung stoppt. Aus X. Li, P.W. Bohn, Metal-assisted chemical etching in HF/H2O2 produces porous silicon, Appl. Phys. Lett., Vol.77, No.16, p. 2572-2574, 2000, American Institute of Physics, ist es bekannt, poröse Siliziumstrukturen mittels Metall-induziertem nasschemischem Ätzen (engl.: metal-assisted chemical etching = MACE) zu erzeugen.

Weitere Aspekte des Metall-induzierten Ätzens werden auch dargelegt in dem Artikel von Eduard Monaico et al: "Porous semiconductor compounds", SEMICONDUCTOR SCIENCE TECHNOLOGY, IOP PUBLISHING LTD, GB, Bd. 35, Nr. 10, 31. August 2020.

ZUSAMMENFASSUNG

Ein erfindungsgemäßes Verfahren zur Herstellung einer hierarchisch porösen Struktur umfasst ein Beschichten einer makroporösen Struktur mit Metallnanopartikeln, ein Metall-induziertes Ätzen der beschichteten makroporösen Struktur zur Erzeugung von Durchgangsporen, welche sich durch die Porenwände der Makroporen der beschichteten makroporösen Struktur erstrecken, und ein thermisches Oxidieren der geätzten beschichteten makroporösen Struktur. Die thermisch oxidierte geätzte beschichtete makroporöse Struktur kann dabei eine mit der beschichteten makroporösen Struktur übereinstimmende Makroporenkonfiguration aufweisen.

Dabei sind unter dem Begriff "Makroporen", wie er im Rahmen der vorliegenden Beschreibung und der Ansprüche verwendet wird, insbesondere Poren mit einer Größe von mehr als 100 nm zu verstehen. Die Makroporen können regelmäßig oder statistisch über die makroporöse Struktur verteilt sein. Die Makroporen können als Durchgangsporen ausgebildet sein. Die Durchgangsporen können sich entlang paralleler Achsen erstrecken. Die Dichte der Makroporen kann über das Volumen der makroporösen Struktur variieren oder konstant sein. Insbesondere kann die makroporöse Struktur regelmäßig angeordnete (zueinander parallele) Durchgangsporen aufweisen.

Ferner sind unter dem Begriff "Metallnanopartikel", wie er im Rahmen der vorliegenden Beschreibung und der Ansprüche verwendet wird, insbesondere Metallpartikel mit einer Größe von weniger als 100 nm zu verstehen. Die Metallnanopartikel können Silber, Gold, Platin oder ein anderes katalytisches Material umfassen. Bspw. können die Metallnanopartikel als Silbernanopartikel ausgebildet sein.

Die makroporöse Struktur kann Silizium umfassen und insbesondere aus (dotiertem) Silizium gebildet sein (bspw. aus mit Phosphor oder Bor dotiertem Silizium). Z. B. kann die makroporöse Struktur als (dotierte) monokristalline (makroporöse) Siliziummembran ausgebildet sein. Die Siliziummembran kann eine <100> Kristallorientierung parallel zur Oberfläche der Siliziummembran aufweisen. Durch das thermische Oxidieren bei Temperaturen unterhalb der Schmelztemperatur von Silizium (z.B. bei 800-1100 °C) kann eine pseudomorphe Transformation des Materials erzielt werden, bei der eine amorphe hierarchisch poröse Quarzglasstruktur erzeugt wird. Bspw. kann durch das thermische Oxidieren eine amorphe hierarchisch poröse Quarzglasmembran erzeugt werden.

Das Beschichten der makroporösen Struktur kann ein Eintauchen der Struktur in eine Silbernitratlösung oder ein Benetzen der Struktur mit der Silbernitratlösung umfassen. Die Silbernitratlösung kann mit wässriger Flusssäure gemischt sein. Die Struktur kann für weniger als 10 s (Fällungszeit) in der Mischung sein. Nach dem Entfernen der Struktur aus der Lösung kann die Struktur (z. B. in einem Glasrohrofen) bei einer Temperatur von über 200°C für eine Zeit von mehr als 30 Minuten (Auslagerungszeit) in einer Schutzatmosphäre ausgelagert werden. Bspw. kann die Struktur bei einer Temperatur von 400°C für eine Stunde in einer Argonatmosphäre ausgelagert werden. Die Größe und Form der Silbernanopartikel kann über die Silbernitratkonzentration der Fällungslösung, die Fällungszeit und die Auslagerungstemperatur/-zeit gesteuert werden.

Nach der Auslagerung kann die beschichtete makroporöse Struktur gekühlt werden. Bspw. kann die beschichtete makroporöse Struktur aus dem Ofen entnommen werden und über einen Zeitraum von mehr als 10 Minuten (z. B. 30 Minuten) bei Raumtemperatur abkühlen.

Die beschichtete makroporöse Struktur kann mit einer Mischung aus veränderlichen Anteilen von Wasserstoffperoxid, Ethanol und Flusssäure geätzt werden. Die Mischung kann eine Bewegung (Wanderung) der Silbernanopartikel in horizontaler Richtung ermöglichen. Die Bewegung (Wanderung) kann statistisch sein. Dementsprechend kann die Porosität der mesoporösen Porenwände der Makroporen isotrop sein. Die Expositionszeit der beschichteten makroporösen Struktur in der Ätzlösung kann wenige Minuten (z.B. 10 Minuten) bis zu Stunden (z.B. 3 Stunden) betragen. Durch die Variation der Expositionszeit kann die Porosität, die Porengrößenverteilung und die Länge der Mesoporen eingestellt werden.

Eine erfindungsgemäße hierarchisch poröse Struktur umfasst eine makroporöse Grundstruktur mit mesoporösen Porenwänden, wobei die mesoporösen Porenwände isotrope Durchgangsporen aufweisen und die hierarchisch poröse Struktur freistehend, selbsttragend und allseitig offen ist.

Die hierarchisch poröse Struktur kann als Siliziummembran oder als Quarzglasmembran ausgebildet sein. Die Membran kann eine im Wesentlichen konstante Dicke aufweisen. Die Membran kann ferner so in einer Halterung angeordnet sein, dass ein Stofftransport in alle Richtungen der Membran möglich ist.

Die makroporöse Grundstruktur kann Makroporen aufweisen, welche sich quer zu einer Ebene erstrecken und mit den, sich parallel zur Ebene erstreckenden Durchgangsporen der mesoporösen Porenwände, ein durchgängiges Porennetzwerk bilden. Die Hierarchie in den Makroporenwänden kann statistisch verteilt und das Porennetzwerk kann schwammartig aufgebaut sein.

Die Makroporen können statistisch, hexagonal oder auch quadratisch angeordnet sein und runde oder quadratische Porenöffnungen aufweisen.

Die hierarchisch poröse Siliziumstruktur kann eine Porosität von mehr als 50% und insbesondere eine Porosität von mehr als 60% aufweisen.

KURZBESCHREIBUNG DER ZEICHNUNGEN

Die Erfindung wird nachfolgend in der detaillierten Beschreibung anhand eines Ausführungsbeispiels erläutert, wobei auf Zeichnungen Bezug genommen wird, in denen:

Fig. 1 eine schematische Querschnittsansicht einer beispielhaften makroporösen Struktur zeigt;

Fig. 2 das Abscheiden von Metallnanopartikeln auf die in Fig. 1 gezeigte makroporöse Struktur illustriert;

Fig. 3 eine Draufsicht auf eine beispielhafte makroporöse Struktur zeigt, auf die Metallnanopartikel abgeschieden wurden;

Fig. 4 eine Detail- und eine Querschnittsansicht der in Fig. 3 gezeigten beispielhaften makroporösen Struktur zeigt;

Fig. 5 das Porosifizieren der Porenwände der makroporösen Struktur schematisch illustriert;

Fig. 6 die Oberfläche der hierarchisch strukturierten Membran mit sichtbaren Porenöffnungen der anisotropen Makroporen zeigt;

und Fig. 7 einen Querschnitt der Membran mit anisotropen Makroporen und porosifizierten Porenwänden zeigt;

Fig. 8 ein Ablaufdiagramm von Prozessschritten zeigt;

Fig. 9 den Einfluss steigender Ätzzeiten auf die Porosität und die Porengrößenverteilung illustriert;

Fig. 10 ein Ablaufdiagramm des Prozesses zeigt; und

Fig. 11 einen Querschnitt durch eine makroporöse Ausgangsstruktur und aus der Ausgangsstruktur unter Verwendung des Prozesses erzeugte hierarchisch poröse Strukturen zeigt.

Dabei sind in den Zeichnungen, die nicht notwendigerweise maßstabsgetreu sein müssen, gleiche oder funktional ähnliche Elemente durch gleiche Bezugszeichen gekennzeichnet.

DETAILLIERTE BESCHREIBUNG

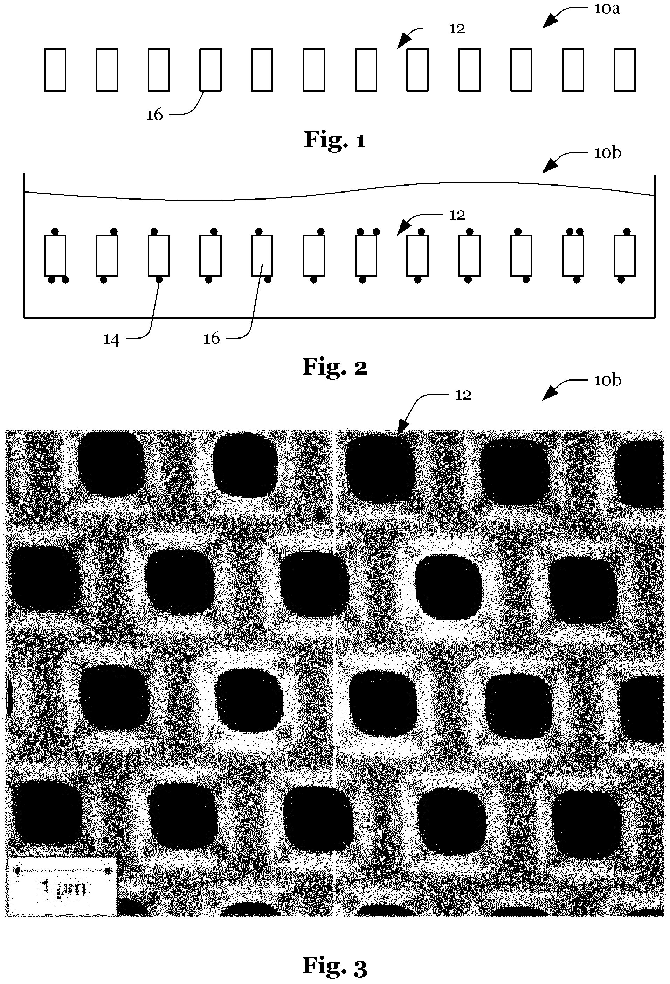

Fig. 1 zeigt eine schematische Querschnittsansicht einer mit Phosphor (n) dotierten monokristallinen Silizium-Struktur 10a in Form einer Membran, welche bspw. von der Firma SmartMembranes aus Halle (Saale) bezogen werden kann. Struktur 10a hat eine <100> Kristallorientierung parallel zur Oberfläche und ist makroporös. Die Makroporen 12 sind hexagonal angeordnet und besitzen einen Porendurchmesser von 1 $\mu$m und einen Abstand von 1,5 $\mu$m (gemessen von Porenmitte zu Porenmitte). Die makroporöse Struktur 10a kann 0,06-0,5 mm dick sein und wurde, bevor die Beschichtung mit Metallnanopartikeln 14 durchgeführt wurde, in einem Ofen bei 750°C unter sauerstoffhaltiger Atmosphäre für mindestens drei Stunden künstlich gealtert.

Fig. 2 illustriert das Abscheiden von Metallnanopartikeln 14 (AgNP) auf die in Fig. 1 gezeigte makroporöse Struktur 10a. Die Fällung der Metallnanopartikel 14 wurde nasschemisch mit einer Fällungslösung durchgeführt. Die Fällungslösung besteht aus 25 ml wässriger 1 mM Silbernitratlösung und 5 ml 10%-iger wässriger Flusssäure. Für die Beschichtung wurde die makroporöse Struktur 10a für fünf Sekunden in die Lösung getaucht und anschließend im Abzug getrocknet.

Die freien Silberionen (Ag$^+$) aus der Lösung werden an der Silizium-Oberfläche durch Aufnahme eines Elektrons (e$^-$) reduziert und fallen als elementares Silber aus. Mit steigender Depositionszeit nimmt die Partikelgröße zu bis dendritisches Kristallwachstum beginnt. Neben der Fällungszeit hat auch die Konzentration an Silbernitrat einen Einfluss auf die Größe und Form der Metallnanopartikel 14. Um eine optimale Form der Metallnanopartikel 14 zu erhalten, kann die beschichtete makroporöse Struktur 10b vor dem Ätzen in einem Glasrohrofen in Argonatmosphäre bei 400 °C für eine Stunde ausgelagert werden. Die beschichtete makroporöse Struktur 10b kann danach für weitere 30 min im Glasrohr verbleiben, um abzukühlen, und dann entnommen werden.

Fig. 3 zeigt eine Draufsicht auf die beschichtete makroporöse Struktur 10b, welche mit einem Rasterelektronenmikroskop (REM) (Zeiss, Leo Gemini 1530) angefertigt wurde. Die Makroporen 12 zeigen an der Oberfläche konisch zulaufende Öffnungen und zwischen den Makroporen 12 auf die Oberfläche abgeschiedene Metallnanopartikel 14, welche als helle Punkte auf der beschichteten makroporösen Struktur 10b zu erkennen sind.

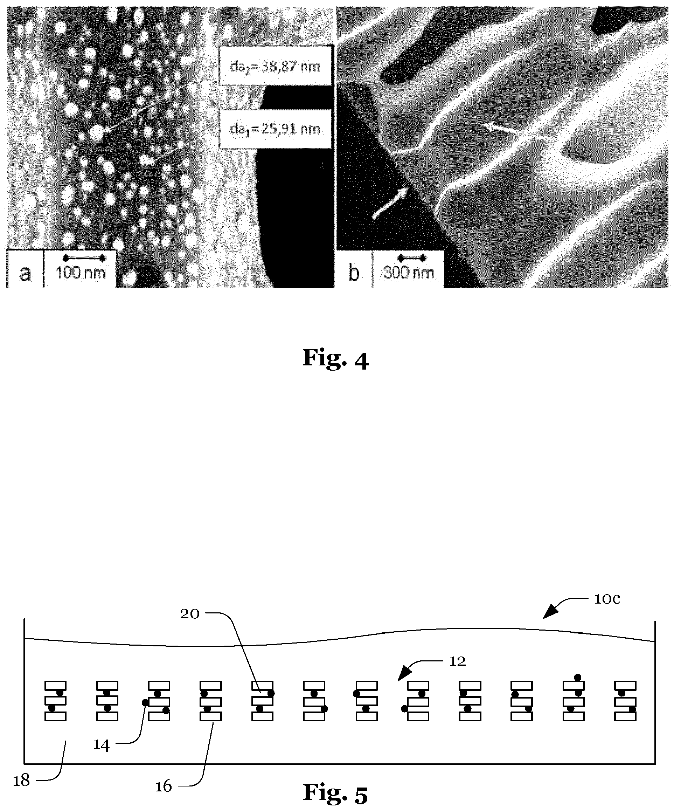

Fig. 4 zeigt eine Detail- und eine Querschnittsansicht der in Fig. 3 gezeigten beschichteten makroporösen Struktur 10b. Diese zeigt, dass sich die Metallnanopartikel 14 (< 50 nm und rund) an den Porenöffnungen abgeschieden haben. Im Inneren der beschichteten makroporösen Struktur 1ob sind keine Metallnanopartikel 14 nachweisbar.

Fig. 5 illustriert die Porosifizierung der Porenwände 16 der beschichteten makroporösen Struktur 10b mittels Metall-induzierten Ätzens. Die Ätzlösung 18 bestand aus einer 1:1:1 Volumenmischung von Wasserstoffperoxid (H2O2, 30%), Ethanol (EtOH, 99,9%) und Flusssäure (HF, 48%). Zunächst wurde eine 1:1 Mischung aus EtOH und HF angesetzt. Nachdem 5 ml des Oxidationsmittels $H_2O_2$ in einen Teflonbecher gefüllt wurden, wurden 10 ml der HF/EtOH-Mischung hinzugegeben. Die beschichtete makroporöse Struktur 10b wurde in die Lösung 18 gegeben und verblieb dort für 45 min. Danach wurde die hierarchisch poröse Struktur 10c aus der Lösung 18 herausgenommen, mit deionisiertem Wasser gespült und anschließend (bspw. im Abzug) getrocknet.

Während des Ätzens injizierten die Metallnanopartikel 14 unter Anwesenheit eines Oxidationsmittels Ladungs-Löcher (h$^+$) in die beschichtete makroporöse Struktur 10b. Die Reduktion des Oxidationsmittels fand gemäß der folgenden Gleichung an der Metalloberfläche statt.

$$H_2O_2 + 2H^+ \rightarrow 2H_2O + 2h^+$$

Die injizierten Löcher oxidierten das Silizium an der Grenzfläche Silber-Silizium und ermöglichen einen nukleophilen Angriff der Fluoridionen auf die Si-Si-Bindung. Die gesamte Reaktionsgleichung im Auflösungsprozess lautet wie folgt.

$$Si + 6HF + nh^+ \rightarrow H_2SiF_6 + nH^+ + \frac{4-n}{2}H_2 \uparrow$$

Die Auflösung des Siliziums hängt von der Konzentration der Flusssäure und des Oxidationsmittels ab, aber auch von der Größe, Form und Art der Metallnanopartikel 14.

Die Metallnanopartikel 14 sinken nicht in das Silizium ab, sondern lösen sich während des Ätzens von der Oberfläche und sind in der Lösung 18 mobil. Die Synthese von Mesoporen 20 findet dadurch nicht nur an der Oberfläche, sondern auch im Inneren der beschichteten makroporösen Struktur 10b statt, was zu den mesoporösen Porenwänden 16 führt.

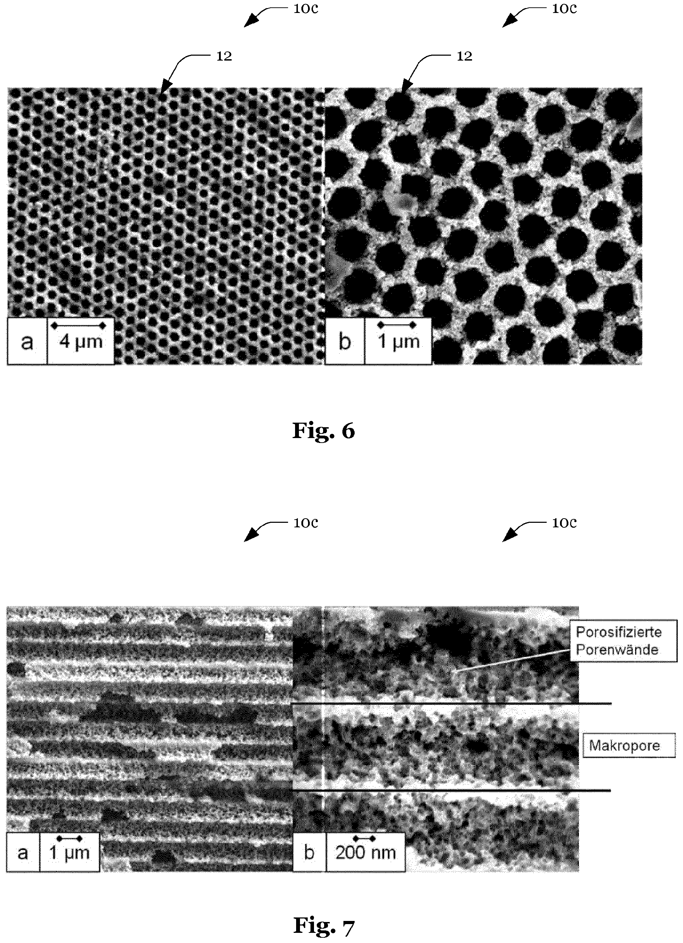

Fig. 6 zeigt die Oberfläche der hierarchisch porösen Struktur 10c. Die Makroporen 12 wurden durch die Porosifizierung geweitet und die konisch zulaufenden Porenöffnungen sind nicht mehr zu erkennen. Die Oberfläche zwischen den Makroporen 12 erscheint schuppig und rau und nicht mehr glatt.

Fig. 7 zeigt eine Querschnittsansicht der hierarchisch porösen Struktur 10c an einer Bruchkante (wodurch Defekte wie bspw. Abplatzungen zu sehen sind). Die Porenwände 16 der von links nach rechts verlaufenden Makroporen 12 sind von einem scheinbar ungeordneten Netzwerk von kleineren Poren 20 (Mesoporen) durchzogen. Diese kleineren Poren 20 sind weniger als 100 nm groß und durchdringen die Porenwände 16.

Hinsichtlich der hierarchisch porösen Struktur 10c ergibt sich eine Porosität von fast 70%.

| Probe | Dichte | Porosität |
|---|---|---|
| Bulk-Silizium | 2.33 g/cm$^3$ | 0% |
| Siliziummembran | 1.28 g/cm$^3$ | ~ 45 % |
| Hierarchisch poröses Si | 0.76 g/cm$^3$ | ~ 69 % |

Die hierarchisch poröse Struktur 10c ist, wie das Ausgangsmaterial, monokristallin und umfasst keinen signifikanten Anteil an Rest-Silber. Ferner besitzt sie nach dem Ätzen nahezu unverändert Maße wie die ursprüngliche Struktur 10a. Es findet lediglich eine Ausdünnung statt (bspw. Ein Verlust an Dicke von 10%), sodass die hierarchisch poröse Struktur 10c etwas dünner ist.

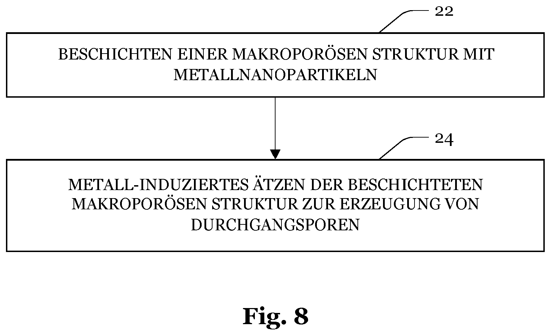

Fig. 8 zeigt ein Ablaufdiagramm der Prozessschritte. Bei Schritt 22 beginnt der Prozess mit dem Abscheiden der Metallnanopartikel 14 auf die makroporöse Struktur 10a. Bei Schritt 24 wird der Prozess mit dem Metall-induzierten Ätzen der beschichteten makroporösen Struktur 10b zur Erzeugung von Durchgangsporen 20, welche sich durch die Porenwände 16 der Makroporen 12 erstrecken, fortgesetzt.

Der Ätzprozess mit mobilen Metallnanopartikeln 14 ermöglicht dabei die Synthese neuer Strukturen, die bisher noch nicht zugänglich waren.

Im vorliegenden Beispiel wurde dadurch eine hierarchisch poröse Struktur 10c erzeugt, die aus lateral hexagonal angeordneten, 1 μm großen Makroporen 12 und einem feinen Porennetzwerk mit weniger als 100 nm großen Poren 20 besteht, welches die Porenwände 16 durchdringt. Die hierarchisch poröse Struktur 10c war auch noch nach der Porosifizierung monokristallin und erreichte eine Porosität von fast 70%.

Durch die hierarchische Porosität kann die Infiltration von Stoffen in die Porenräume verbessert werden und eine optimale Füllung der hierarchisch porösen Struktur 10c erleichtert werden.

Die große Oberfläche im Poreninneren bietet die Möglichkeit einer Funktionalisierung des Materials, wodurch Eigenschaften wie die elektrische oder thermische Leitfähigkeit verbessert oder die Oberfläche modifiziert werden kann.

Eine Anwendung als Filter- oder Sensormaterial, aber auch als neues Anodenmaterial in der Batterieforschung ist ebenfalls denkbar.

Die Synthese von hierarchisch porösem Silizium über das Silber katalysierte Ätzen ermöglicht durch Anpassungen der Herstellungsparameter eine Steuerung der entstehenden Porosität. Die wichtigsten Herstellungsparameter, die für eine individuelle Strukturanpassung verändert werden können, sind die Ätzzeit, die Zusammensetzung der Ätzlösung und die Konzentration an abgeschiedenen Silberpartikeln. Durch individuelle Anpassung der Parameter kann der Prozess zur Herstellung hierarchisch poröser Membranen unterschiedlicher Abmessungen (bspw. Für Membranen mit einer Kantenlänge von 1 bis 5 Zentimetern und einer Dicke von 10 bis 500 μm) verwendet werden.

Dabei hat sich gezeigt, dass sich die Ätzzeit durch Vergrößern des relativen Anteils an Wasserstoffperoxid verkürzt und umgekehrt durch Vergrößern des relativen Anteils an HF verlängert. Somit steht die Ätzrate in direktem Zusammenhang mit den Konzentrationsverhältnissen. Durch Erhöhen der Silberkonzentration und Vergrößern des relativen Anteils an $H_2O_2$ wird eine höhere Porosität erreicht, während ein Vergrößern des relativen Anteils an HF zusammen mit einem Erhöhen der Konzentration an AgNP (bei konstant gehaltener Ätzzeit) zu einer geringeren Porosität führt. Die Morphologie der synthetisierten Poren wiederum wird durch Vergrößern des Anteils an HF gerader und gleichförmiger und die Porendurchmesser kleiner, während durch Vergrößern des relativen Anteils von $H_2O_2$ die Größenverteilung breiter wird und sich eine isotrope, schwammartige Struktur ausbildet.

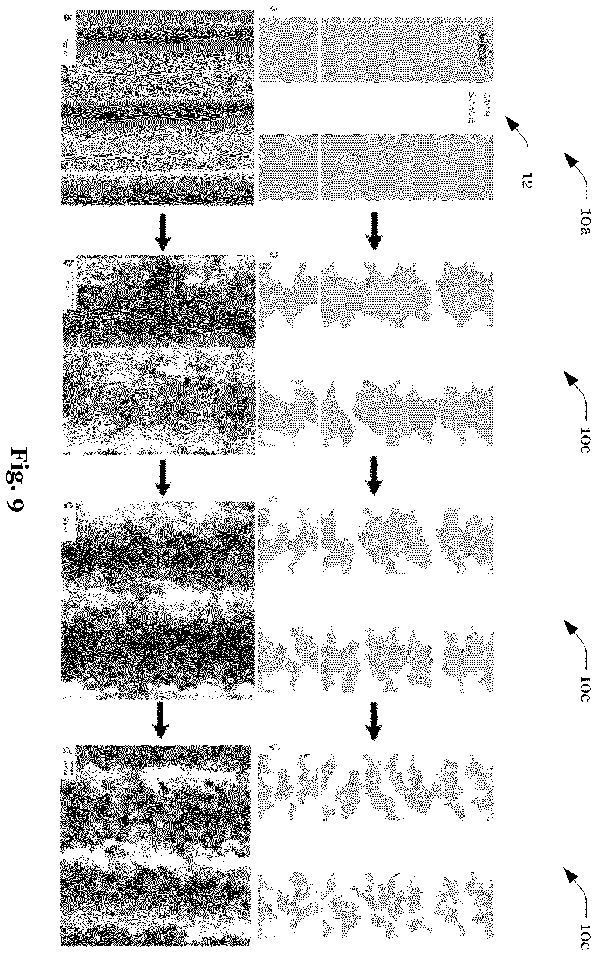

Fig. 9 illustriert dazu in der oberen Bildreihe (a)-(d) schematisch, wie sich bei steigenden Ätzzeiten und konstanten Konzentrationen an HF, $H_2O_2$ und AgNP die Porosität und die Porengrößenverteilung durch Bildung immer weiterer Durchgangsporen schrittweise erhöht. In der unteren Bildreihe sind zur oberen Bildreihe korrespondierende rasterelektronenmikroskopische (REM) Aufnahmen gezeigt. Das erste Bild (a) zeigt eine makroporöse Siliziummembran mit geraden Durchgangsporen und massiven Porenwänden. Die Bilder (b) bis (d) zeigen, wie sich durch das Ätzen mit AgNP mit steigender Expositionszeit eine höhere Porosität ausbildet und die initialen wie auch die synthetisierten Poren in ihren Durchmessern zunehmen. Die gezeigten Aufnahmen verdeutlichen auch die Zunahme der inneren Oberfläche mit steigender Porosität. Wird die Ätzzeit weiter vergrößert, verringert sich die innere Oberfläche wieder und die Struktur geht verloren, da sie beginnt, sich lokal aufzulösen.

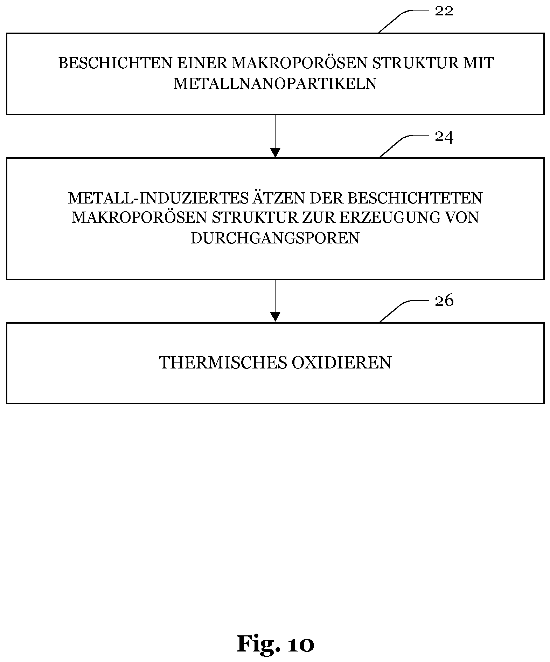

Wie in Fig. 10 gezeigt kann der Prozess um einen Schritt 26 des thermischen Oxidierens erweitert werden. Durch das thermische Oxidieren kann das hierarchisch poröse Silizium (vollständig) in amorphes Quarzglas umgewandelt werden, wobei die bestehende Porosität zu großen Teilen erhalten bleibt. Bspw. kann das hierarchisch poröse Silizium für 48 Stunden (je nach erzeugter Porosität auch länger bzw. kürzer) bei 800 - 1100 °C (hier für 48 Stunden bei 900°C) in einem Ofen mit sauerstoffhaltiger Atmosphäre gelagert werden. Während der Oxidation diffundiert Sauerstoff in die Struktur, wodurch aus monokristallinem Silizium amorphes poröses Glas geformt wird.

Aus dieser Implantation von Sauerstoff folgt eine makroskopische Volumenzunahme von bis zu 10%. Die Expansion der gesamten Membran fällt geringer aus als bei einem Bulk-/Vollvolumenmaterial. Der Grund für die geringere Expansion liegt in der Struktur des hierarchisch porösen Siliziums, da es durch den Oxidationsprozess zu einer Verdichtung des Materials kommt, bei der die Porosität abnimmt, d. h. die Poren kleiner werden und kleinste Mikroporen verschwinden (indem die gegenüberliegenden Porenwände dieser Bereiche miteinander verschmelzen).

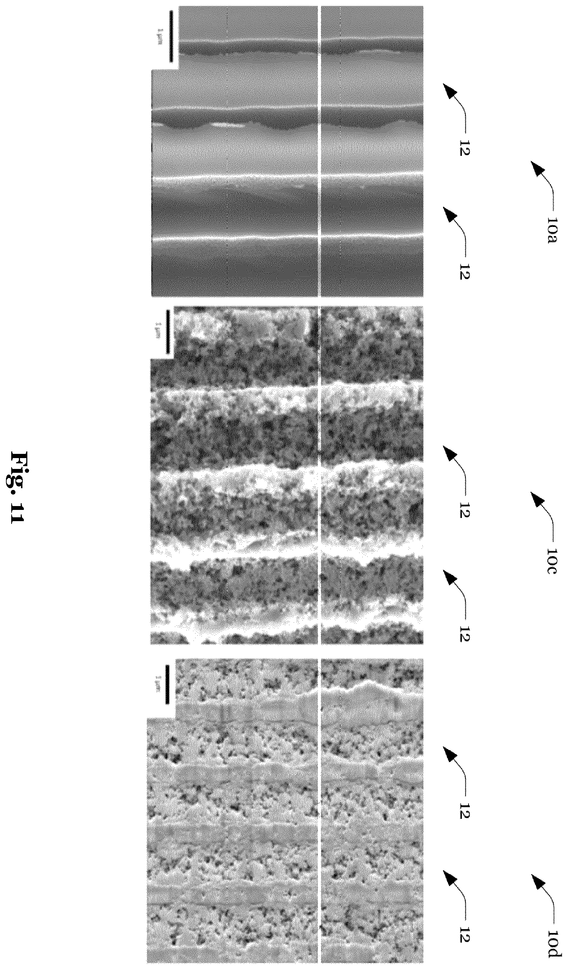

In Fig. 11 zeigen REM-Aufnahmen eines Querschnitts durch eine makroporöse Struktur 10a aus monokristallinem Silizium, eine hierarchisch poröse Struktur 10c aus Silizium und eine hierarchisch poröse Struktur 10d aus Quarzglas. Dabei ist zu erkennen, dass die Makroporen 12, welche sich von oben nach unten erstrecken, nach der Oxidation eine verringerte innere Oberfläche und kleinere Porendurchmesser in den Wänden aufweisen. Trotzdem sind die Mesoporen Durchgangsporen und verbinden die Makroporen miteinander, was einen lateralen Stofftransport durch die hierarchisch poröse Struktur 10d ermöglicht. Zudem wird durch das Oxidieren die Porengrößenverteilung kleiner, da kleinste Poren verschwinden und größte Porendurchmesser durch die Expansion der Porenwände schrumpfen, und die innere Rauigkeit der Makroporenwände nimmt durch die Oxidation ab.

Die gezeigten hierarchisch porösen Strukturen 10c und 10d können bspw. als Aktuator in (bio-) medizinischen Implantaten, als Mikroreaktoren in sogenannten Lab-on-a-Chip Systemen oder auch als Anodenmaterial in neuartigen Energie-Speichersystemen, wie Batterien oder Superkondensatoren, eingesetzt werden. Ferner können hierarchisch poröse Quarzgläser als Matrix für Hybridmaterialien dienen um bspw. schaltbare optische Linsen zu erzeugen oder um in Chromatographieverfahren als Filtermembranen eingesetzt zu werden.

BEZUGSZEICHENLISTE

10a    makroporöse Struktur
10b    beschichtete makroporöse Struktur
10c    hierarchisch poröse Struktur
1od    hierarchisch poröse Struktur
12    Makropore
14    Metallnanopartikel
16    Porenwand
18    Lösung
20    Pore
22    Prozessschritt
24    Prozessschritt
26    Prozessschritt

**Patentansprüche**

1.    Verfahren zur Herstellung einer hierarchisch porösen Struktur (10d), umfassend:

Beschichten einer makroporösen Struktur (10a) mit Metallnanopartikeln (14); und
Metall-induziertes Ätzen (24) der beschichteten makroporösen Struktur (10b) zur Erzeugung von Durchgangsporen (20), welche sich durch Porenwände (16) von Makroporen (12) der beschichteten makroporösen Struktur (10b) erstrecken; und
thermisches Oxidieren (26) der geätzten beschichteten makroporösen Struktur (10c).

2.    Verfahren nach Anspruch 1, wobei die thermisch oxidierte geätzte beschichtete makroporöse Struktur (10d) eine mit der beschichteten makroporösen Struktur (10a) übereinstimmende Makroporenkonfiguration aufweist.

3.    Verfahren nach Anspruch 1 oder 2, wobei die Struktur (10a) Silizium umfasst.

4.    Verfahren nach Anspruch 3, wobei die Struktur (10a) als monokristalline makroporöse Siliziummembran ausgebildet ist.

5.    Verfahren nach Anspruch 3 oder 4, wobei die oxidierte Struktur (10d) als hierarchisch poröse Quarzglasmembran ausgebildet ist.

6.    Verfahren nach einem der Ansprüche 1 bis 5, wobei die Metallnanopartikel (14) Silbernanopartikel sind.

7.    Verfahren nach Anspruch 6, wobei das Beschichten der makroporösen Struktur (10a) ein Eintauchen der makroporösen Struktur (10a) in eine Silbernitratlösung oder das Benetzen der makroporösen Struktur (10a) mit einer Silbernitratlösung umfasst.

8. Verfahren nach Anspruch 6 oder 7, wobei die beschichtete makroporöse Struktur (10b) mit einer Mischung aus Wasserstoffperoxid, Ethanol und Flusssäure geätzt wird.

9. Verfahren nach Anspruch 8, wobei die Mischung eine Bewegung der Silbernanopartikel (14) in horizontaler Richtung ermöglicht.

10. Hierarchisch poröse Struktur (10d), umfassend:

    eine makroporöse Grundstruktur mit mesoporösen Porenwänden (16);
    **dadurch gekennzeichnet, dass**
    die mesoporösen Porenwände (16) isotrope Durchgangsporen (20) aufweisen
    und
    die hierarchisch poröse Struktur (10d) freistehend, selbsttragend und allseitig offen ist.

11. Hierarchisch poröse Struktur (1od) nach Anspruch 10, wobei die makroporöse Grundstruktur Makroporen (12) aufweist, welche sich quer zu einer Ebene erstrecken und mit den sich parallel zur Ebene erstreckenden Durchgangsporen (20) der mesoporösen Porenwände (16) ein durchgängiges Porennetzwerk bilden.

12. Hierarchisch poröse Struktur (1od) nach Anspruch 10 oder 11, wobei die hierarchisch poröse Struktur (1od) eine Porosität von mehr als 50% aufweist.

13. Hierarchisch poröse Struktur (1od) nach einem der Ansprüche 10 bis 12, wobei die hierarchisch poröse Struktur (10d) als freistehende, selbsttragende und allseitig offene Membran ausgebildet ist.

14. Hierarchisch poröse Struktur (1od) nach einem der Ansprüche 10 bis 12, wobei die hierarchisch poröse Struktur (10d) aus amorphem Quarzglas besteht.

**Claims**

1. A method for producing a hierarchically porous structure (10d), comprising:

    coating a macroporous structure (10a) with metal nanoparticles (14); and
    metal-induced etching (24) of the coated macroporous structure (10b) to generate through pores (20) extending through pore walls (16) of macropores (12) of the coated macroporous structure (10b); and
    thermally oxidizing (26) of the etched coated macroporous structure (10c).

2. The method of claim 1, wherein the thermally oxidized etched coated macroporous structure (10d) comprises a macropore configuration matching that of the coated macroporous structure (10a).

3. The method of claim 1 or 2, wherein the structure (10a) comprises silicon.

4. The method of claim 3, wherein the structure (10a) is a monocrystalline macroporous silicon membrane.

5. The method of claim 3 or 4, wherein the oxidized structure (10d) is a hierarchical porous quartz glass membrane.

6. The method of any one of claims 1 to 5, wherein the metal nanoparticles (14) are silver nanoparticles.

7. The method of claim 6, wherein the coating of the macroporous structure (10a) comprises immersing the macroporous structure (10a) in a silver nitrate solution or wetting the macroporous structure (10a) with a silver nitrate solution.

8. The method of claim 6 or 7, wherein the coated macroporous structure (10b) is etched with a mixture of hydrogen peroxide, ethanol, and hydrofluoric acid.

**9.** The method of claim 8, wherein the mixture enables movement of the silver nanoparticles (14) in a horizontal direction.

**10.** A hierarchical porous structure (10d), comprising:

a macroporous base structure with mesoporous pore walls (16);
**characterized in that**
the mesoporous pore walls (16) comprise isotropic through pores (20)
and
the hierarchical porous structure (10d) is freestanding, self-supporting, and open on all sides.

**11.** The hierarchical porous structure (10d) of claim 10, wherein the macroporous base structure comprises macropores (12) which extend transversely to a plane and form a continuous pore network with the through pores (20) of the mesoporous pore walls (16) which extend parallel to the plane.

**12.** The hierarchical porous structure (10d) of claim 10 or 11, wherein the hierarchical porous structure (10d) exhibits a porosity of more than 50%.

**13.** The hierarchical porous structure (10d) of any one of claims 10 to 12, wherein the hierarchical porous structure (10d) is configured as a freestanding, self-supporting, and open on all sides membrane.

**14.** The hierarchical porous structure (10d) of any one of claims 10 to 12, wherein the hierarchical porous structure (10d) consists of amorphous quartz glass.

**Revendications**

**1.** Procédé de fabrication d'une structure poreuse hiérarchiquement (10d) comprenant :

un revêtement d'une structure macroporeuse (10a) avec des nanoparticules métalliques (14) ; et
une gravure induite métalliquement (24) de la structure macroporeuse (10b) revêtue pour la génération de pores traversants (20) qui s'étendent par des parois de pore (16) de macropores (12) de la structure macroporeuse (10b) revêtue ; et
une oxydation thermique (26) de la structure macroporeuse (10c) revêtue gravée.

**2.** Procédé selon la revendication 1, dans lequel la structure macroporeuse (10d) revêtue gravée thermiquement oxydée présente une configuration macroporeuse coïncidant avec la structure macroporeuse (10a) revêtue.

**3.** Procédé selon la revendication 1 ou 2, dans lequel la structure (10a) comprend du silicium.

**4.** Procédé selon la revendication 3, dans lequel la structure (10a) est formée comme membrane de silicium macroporeuse monocristalline.

**5.** Procédé selon la revendication 3 ou 4, dans lequel la structure oxydée (10d) est formée comme membrane de verre de quartz poreuse hiérarchiquement.

**6.** Procédé selon l'une quelconque des revendications 1 à 5, dans lequel les nanoparticules métalliques (14) sont des nanoparticules d'argent.

**7.** Procédé selon la revendication 6, dans lequel le revêtement de la structure macroporeuse (10a) comprend un enfoncement de la structure macroporeuse (10a) dans une solution de nitrate d'argent ou l'humidification de la structure macroporeuse (10a) avec une solution de nitrate d'argent.

**8.** Procédé selon la revendication 6 ou 7, dans lequel la structure macroporeuse (10b) revêtue est gravée avec un mélange de peroxyde d'hydrogène, d'éthanol et d'acide fluorhydrique.

**9.** Procédé selon la revendication 8, dans lequel le mélange permet un mouvement de nanoparticules d'argent (14) dans le sens horizontal.

**10.** Structure poreuse hiérarchiquement (10d) comprenant :

une structure de base macroporeuse avec des parois de pores (16) mésoporeuses ;
**caractérisée en ce que**
les parois de pore (16) mésoporeuses présentent des pores traversants (20) isotropes
et
la structure poreuse hiérarchiquement (10d) est autonome, autoportante et ouverte de tous côtés.

**11.** Structure poreuse hiérarchiquement (10d) selon la revendication 10, dans lequel la structure de base macroporeuse présente des macropores (12) qui s'étendent transversalement à un plan et forment un réseau de pores continu avec les pores traversants (20) s'étendant parallèlement au plan des parois de pores (16) mésoporeuses.

**12.** Structure poreuse hiérarchiquement (10d) selon la revendication 10 ou 11, dans lequel la structure poreuse hiérarchiquement (10d) présente une porosité de plus de 50 %.

**13.** Structure poreuse hiérarchiquement (10d) selon l'une quelconque des revendications 10 à 12, dans lequel la structure poreuse hiérarchiquement (10d) est formée comme membrane autonome, autoportante et ouverte de tous côtés.

**14.** Structure poreuse hiérarchiquement (10d) selon l'une quelconque des revendications 10 à 12, dans lequel la structure poreuse hiérarchiquement (10d) se compose de verre de quartz amorphe.

Fig. 1

Fig. 2

Fig. 3

**Fig. 4**

**Fig. 5**

**Fig. 6**

**Fig. 7**

22

BESCHICHTEN EINER MAKROPORÖSEN STRUKTUR MIT METALLNANOPARTIKELN

24

METALL-INDUZIERTES ÄTZEN DER BESCHICHTETEN MAKROPORÖSEN STRUKTUR ZUR ERZEUGUNG VON DURCHGANGSPOREN

**Fig. 8**

Fig. 9

22

```
BESCHICHTEN EINER MAKROPORÖSEN STRUKTUR MIT
METALLNANOPARTIKELN
```

24

```
METALL-INDUZIERTES ÄTZEN DER BESCHICHTETEN
MAKROPORÖSEN STRUKTUR ZUR ERZEUGUNG VON
DURCHGANGSPOREN
```

26

```
THERMISCHES OXIDIEREN
```

**Fig. 10**

EP 4 213 974 B1

**Fig. 11**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10348541 A1

**In der Beschreibung aufgeführte Nicht-Patentliteratur**

- Metal-assisted chemical etching in HF/H2O2 produces porous silicon. **AUS X. LI** ; **P.W. BOHN**. Appl. Phys. Lett.. American Institute of Physics, 2000, vol. 77, 2572-2574

- Porous semiconductor compounds. **EDUARD MONAICO et al.** SEMICONDUCTOR SCIENCE TECHNOLOGY. IOP PUBLISHING LTD, 31 August 2020, vol. 35